# EUROPÄISCHE PATENTSCHRIFT

(11) **EP 3 767 163 B1**
(45) Veröffentlichungstag und Bekanntmachung des Hinweises auf die Patenterteilung: **08.02.2023**
(21) Anmeldenummer: 20186563.1
(22) Anmeldetag: 17.07.2020
(51) Int. Cl.: F21S 45/47, F21S 45/49, H05K 1/02, F21V 29/70, H05K 7/20

(54) **STEUERMODUL FÜR EINE BELEUCHTUNGSEINRICHTUNG EINES KRAFTFAHRZEUGS, STEUERGERÄT, LICHTMODUL UND BELEUCHTUNGSEINRICHTUNG**
CONTROL MODULE FOR A LIGHTING DEVICE OF A MOTOR VEHICLE, CONTROL DEVICE, LIGHT MODULE AND LIGHTING DEVICE
MODULE DE COMMANDE POUR DISPOSITIF D'ÉCLAIRAGE D'UN VÉHICULE AUTOMOBILE, APPAREIL DE COMMANDE, MODULE LUMINEUX ET DISPOSITIF D'ÉCLAIRAGE

(30) Priorität: 19.07.2019 DE 102019119667
(43) Veröffentlichungstag der Anmeldung: 20.01.2021
(73) Patentinhaber: Marelli Automotive Lighting Reutlingen (Germany) GmbH, 72762 Reutlingen (DE)
(72) Erfinder: Blum, Dirk, 72076 Tübingen (DE); Jedek, Andreas, 72793 Pfullingen (DE); Bezirgianidis, Apostolos, 72760 Reutlingen (DE); Jaiser, Thomas, 72138 Kirchentellinsfurt (DE)
(74) Vertreter: DREISS Patentanwälte PartG mbB

(56) Entgegenhaltungen:
- EP-A2- 2 339 231
- DE-A1-102013 204 029
- DE-A1-102015 200 868
- DE-A1-102016 209 611
- JP-A- 2011 023 469
- US-A- 3 212 564
- US-A- 5 896 269
- US-A1- 2002 159 236
- US-A1- 2003 227 750
- US-A1- 2007 146 990
- US-A1- 2017 256 475
- US-A1- 2019 132 939

## Beschreibung

Die Erfindung betrifft ein Steuermodul für eine Beleuchtungseinrichtung eines Kraftfahrzeugs, ein Steuergerät, ein Lichtmodul und eine Beleuchtungseinrichtung.

In bekannten Steuergeräten ist eine thermische Anbindung von Bauelementen an einen Kühlkörper mittels einer Wärmeleitpaste oder Kleber realisiert.

Aus der DE 20 2010 002 406 U1 ist eine Beleuchtungseinrichtung eines Kraftfahrzeugs mit einem DC-/DC-Wandler bekannt. Mindestens eine Halbleiterlichtquelle und der DC-/DC-Wandler sind auf einer Platine angeordnet und die Platine ist an einem Kühlkörper angeordnet. Der DC-/DC-Wandler und die mindestens eine Halbleiterlichtquelle sind auf unterschiedlichen Seiten der Platine angeordnet.

Das Dokument US 2002/159236 A1 offenbart eine Anordnung mit einer Leiterplatte, mit einem Kühlkörper sowie mit einer thermischen Vorspanneinrichtung zwischen Kühlkörper und einem Integrated Circuit (IC) Chip.

Mithin ist es Aufgabe der Erfindung, die Ableitung der von dem elektronischen Bauteil erzeugten Wärmeenergie zu verbessern.

Die der Erfindung zugrunde liegende Aufgabe wird durch ein Steuermodul für eine Beleuchtungseinrichtung eines Kraftfahrzeugs gemäß dem Anspruch 1, ein Steuergerät gemäß einem nebengeordneten Anspruch, ein Lichtmodul gemäß einem nebengeordneten Anspruch und eine Beleuchtungseinrichtung gemäß einem nebengeordneten Anspruch gelöst. Vorteilhafte Weiterbildung finden sich in den Unteransprüchen und in der nachfolgenden Beschreibung von Ausführungsbeispielen.

Ein erster Aspekt dieser Beschreibung betrifft ein Steuermodul für eine Beleuchtungseinrichtung eines Kraftfahrzeugs, wobei das Steuermodul einen Kühlkörper und eine Leiterplatte mit wenigstens einem darauf angeordneten elektronischen Bauelement umfasst, wobei das elektronische Bauelement mittels einer wärmeleitfähigen Vorspanneinrichtung zwischen der Leiterplatte und dem Kühlkörper verklemmt ist, wobei die wärmeleitfähige Vorspanneinrichtung sich an einem Gegenlagerabschnitt des Kühlkörpers abstützt, wobei die wärmeleitfähige Vorspanneinrichtung das elektronische Bauelement in Richtung der Leiterplatte drückt, und wobei der Gegenlagerabschnitt mit der Leiterplatte starr verbunden ist.

Es wird folglich eine Reduzierung des thermischen Widerstandes zwischen dem elektronischen Bauelement und dem Kühlkörper erreicht. Durch Einbau der Vorspanneinrichtung zwischen dem Kühlkörper und dem elektronischen Bauelement auf der Leiterplatte wird der thermische Widerstand reduziert, da beispielsweise Metalle bei ausreichender Materialstärke einen kleineren Wärmeleitwert haben als Wärmeleitpasten.

Mithin ermöglicht das bereitgestellte Steuermodul die Realisierung kleinerer Steuergerätebauformen, da durch die verbesserte Wärmeabfuhr eine höhere Leistung auf gleichem oder kleinerem Raum möglich ist. Die Temperatursituation im Steuergerat oder im Lichtmodul wird also verbessert. Bei Verwendung von elektronischen Bauelementen, die Ihre Wärme nicht an die Leiterplatte, sondern an ein Thermopad auf der Oberseite des Gehäuses abführen, verbessert die federnde Vorspanneinrichtung den Wärmetransport. Auch kann eine benötigte Menge an Wärmeleitpaste bzw. Wärmeleitkleber verringert werden oder die Wärmeleitpaste bzw. der Wärmeleitkleber kann weggelassen werden.

Darüber hinaus gehend gleicht die Vorspanneinrichtung Toleranzen der Bauelementhöhe aus. Auch können mehrere Bauelemente mit unterschiedlichen Höhen kontaktiert werden, insoweit die Höhe der jeweiligen Vorspanneinrichtung angepasst wird.

Erfindungsgemäß ist vorgesehen, dass die wärmeleitfähige Vorspanneinrichtung ein Druckfederelement umfasst.

Das Druckfederelement ermöglich eine einfache Realisierung der Vorspanneinrichtung.

Ein vorteilhaftes Beispiel zeichnet sich dadurch aus, dass die wärmeleitfähige Vorspanneinrichtung einen durch einen insbesondere durch einen Hinterschnitt gebildeten Federabschnitt des Kühlkörpers umfasst.

Vorteilhaft umfasst der Kühlkörper selbst die Vorspanneinrichtung, was die Teileanzahl und damit die Komplexität des Steuermoduls reduziert.

Ein vorteilhaftes Beispiel zeichnet sich dadurch aus, dass der Kühlkörper eine Ausnehmung umfasst, innerhalb welcher sich die wärmeleitfähige Vorspanneinrichtung befindet.

Vorteilhaft wird die Vorspanneinrichtung innerhalb der Ausnehmung geschützt angeordnet.

Ein vorteilhaftes Beispiel zeichnet sich dadurch aus, dass das wenigstens eine elektronische Bauelement sich innerhalb der Ausnehmung befindet.

Mithin findet auch das elektronische Bauelements Schutz innerhalb der Ausnehmung.

Ein vorteilhaftes Beispiel zeichnet sich dadurch aus, dass auf der Leiterplatte ein weiteres elektronisches Bauelement angeordnet ist, und wobei das weitere elektronische Bauelement mittels der wärmeleitfähigen Vorspanneinrichtung zwischen der Leiterplatte und dem Kühlkörper verklemmt ist, wobei die Vorspanneinrichtung das weitere elektronische Bauelement in Richtung der Leiterplatte drückt.

Vorteilhaft drückt die Vorspanneinrichtung eine Mehrzahl von elektronischen Bauelementen in Richtung der Leiterplatte. Damit erfolgt eine Wärmeableitung der Mehrzahl von Bauelementen über eine einzige Vorspanneinrichtung.

Erfindungsgemäß ist vorgesehen, dass zwischen der Vorspanneinrichtung und dem Kühlkörper und/oder zwischen der Vorspanneinrichtung und dem elektronischen Bauelement eine Wärmeleitpaste angeordnet ist.

Vorteilhaft kann die Wärmeleitung mittels der Wärmeleitpaste weiter verbessert werden. Die Spannwirkung der Vorspanneinrichtung verbessert die Leitfähigkeit der gesamten Wärmeleitverbindung zwischen Leiterplatte und Kühlkörper.

Ein zweiter Aspekt der Beschreibung betrifft ein Steuergerät für eine Beleuchtungseinrichtung eines Kraftfahrzeugs, wobei das Steuergerät das Steuermodul gemäß dem ersten Aspekt umfasst.

Ein dritter Aspekt der Beschreibung betrifft ein Lichtmodul für eine Beleuchtungseinrichtung eines Kraftfahrzeugs, wobei das Lichtmodul das Steuermodul gemäß dem ersten Aspekt umfasst.

Ein vierter Aspekt der Beschreibung betrifft eine Beleuchtungseinrichtung eines Kraftfahrzeugs, welche das Steuergerät gemäß dem zweiten Aspekt und/oder das Lichtmodul gemäß dem dritten Aspekt umfasst.

In der Zeichnung zeigen:
- Figur 1: einen schematisch dargestellten Scheinwerfer für ein Kraftfahrzeug;
- Figur 2: ein Steuermodul in einem schematischen Schnitt; und
- Figur 3: das Steuermodul in einem weiteren schematischen Schnitt.

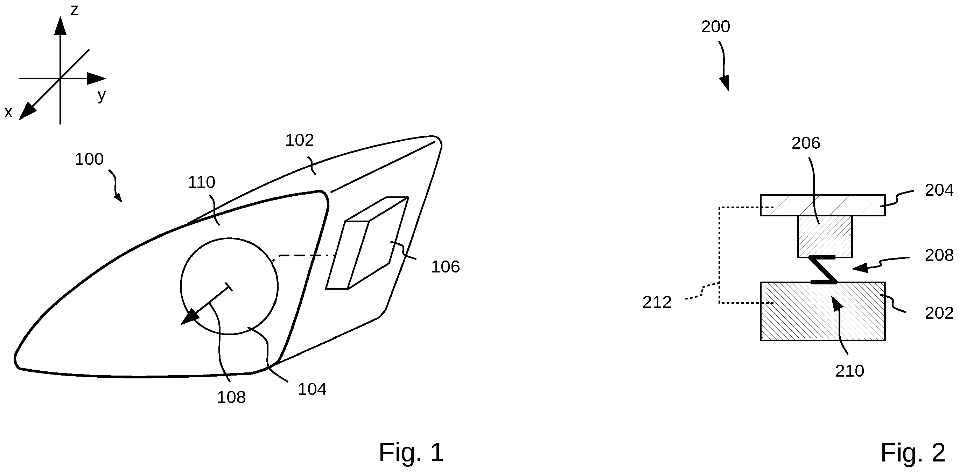

Figur 1 zeigt eine Beleuchtungseinrichtung 100 in Form eines schematisch dargestellten Scheinwerfers für ein Kraftfahrzeug. Selbstverständlich kann die Beleuchtungseinrichtung 100 auch eine Heckleuchte, ein Blinker oder eine andersgeartete Beleuchtungseinrichtung für ein Kraftfahrzeug sein. Innerhalb eines Gehäuses 102 befindet sich ein Lichtmodul 104. Das Lichtmodul 104 wird von einem Steuergerät 106 derart betrieben, dass das Lichtmodul 104 eine Lichtverteilung 108 abstrahlt. Eine Lichtaustrittsöffnung des Gehäuses 102 ist durch eine transparente Abdeckscheibe 110 verschlossen, durch welche die Lichtverteilung 108 durchtritt.

Figur 2 zeigt ein Steuermodul 200 in einem schematischen Schnitt. Das Steuermodul 200 umfasst einen Kühlkörper 202 und eine Leiterplatte 204. Auf einer dem Kühlkörper 202 zugewandten Seite der Leiterplatte 204 ist wenigstens ein elektronischen Bauelement 206 angeordnet. Auf der dem Kühlkörper 202 abgewandten Seite der Leiterplatte 204 können selbstverständlich weitere elektronische Bauelemente angeordnet sein.

Das elektronische Bauelement 206 ist mittels einer wärmeleitfähigen Vorspanneinrichtung 208 zwischen der Leiterplatte 204 und dem Kühlkörper 202 verklemmt. Die wärmeleitfähige Vorspanneinrichtung 208 stützt sich an einem Gegenlagerabschnitt 210 des Kühlkörpers 202 ab. Die wärmeleitfähige Vorspanneinrichtung 208 drückt das elektronische Bauelement 206 in Richtung der Leiterplatte 204. Dies ist möglich, da die Vorspanneinrichtung 208 ein Formgedächtnis aufweist. Das Formgedächtnis der Vorspanneinrichtung 208 ermöglicht eine genaue Abstimmung der zur Herstellung der wärmeleitfähigen Verbindung benötigten Vorspannkraft. Der Gegenlagerabschnitt 210 ist mit der Leiterplatte 204 starr verbunden, was beispielhaft mittels der schematisch dargestellten starren Verbindung 212 dargestellt ist.

Die Leiterplatte 204 umfasst beispielsweise FR4 und wenigstens eine oder mehrere Leiterbahnen, mit welchen das wenigstens eine Bauelement 206 mechanisch und elektrisch kontaktiert ist.

Zwischen der Vorspanneinrichtung 208 und dem Kühlkörper 202 und/oder zwischen der Vorspanneinrichtung 208 und dem elektronischen Bauelement 206 eine Wärmeleitpaste angeordnet ist. Selbstverständlich ist auch eine Realisierung ohne Wärmeleitpaste und ohne Wärmeleitkleber möglich, sie fällt aber nicht unter die beanspruchte Erfindung.

Der Kühlkörper 202 umfasst beispielsweise ein Metall und/oder eine Metalllegierung. Des Weiteren umfasst der Kühlkörper beispielsweise ein Kühlgeometrie wie beispielsweise Kühlrippen, um Wärme an die Umgebung abzugeben.

Die wärmeleitfähige Vorspanneinrichtung 208 umfasst bevorzugt ein Metall bzw. eine Metalllegierung.

Bei dem elektronischen Bauelement 206 handelt es sich beispielsweise um einen Widerstand, eine Spule oder einen Kondensator. Selbstverständlich kann es sich bei dem elektronischen Bauelement 206 auch um ein komplexeres Bauelement wie beispielsweise einen Integrated Circuit in Form eines Stromwandlers handeln.

Die Distanz zwischen dem elektronischen Bauelement 206 und dem Kühlkörper 202 wird durch die Vorspanneinrichtung 208 wärmeleitend überbrückt. Diese beispielsweise metallisch ausgeführte Anbindung an den Kühlkörper 202 leitet die Wärme besser als Wärmeleitpaste oder Kleber. Durch den federnden Aufbau werden die Toleranzen des Bauelements 206, der Leiterplatte 204, der Lötung und des Kühlkörpers 202 ausgeglichen.

Alternativ kann auch der Kühlkörper 202 so ausgeformt sein, dass eine federnde metallische Verbindung zu dem elektronischen Bauelement 206 hergestellt wird. Erfindungsgemäß wird die Vorspanneinrichtung 208 mit Wärmeleitkleber bzw. Wärmeleitpaste kombiniert, um auch bei Vibrationen über die Lebensdauer hinweg eine verbesserte Wärmeanbindung zu gewährleisten. Die Wärmeleitpaste bzw. der Wärmeleitkleber gleicht leichte Unebenheiten der beteiligten Oberflächen aus, was die Wärmeübertragung verbessert. Auch eine Kombination aus Federelement im Kühlkörper 202 und ein Zusatzteil sowie Wärmeleitpaste / -kleber ist denkbar, wobei die Menge der Wärmeleitpaste / -klebers verringert wird.

Das Steuermodul 200 ist beispielsweise Teil des Lichtmoduls 104 aus Figur 1. So ist auf der dem Kühlkörper 202 abgewandten Seite der Leiterplatte 204 wenigstens eine lichterzeugende Halbleiterlichtquelle angeordnet.

Das Steuermodul 200 ist beispielsweise Teil des Steuergeräts 106 aus Figur 1.

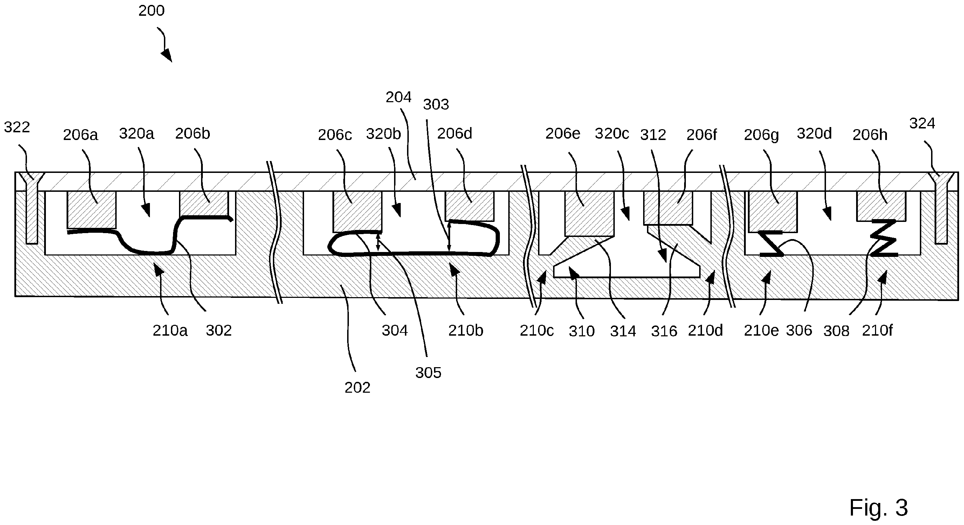

Figur 3 zeigt das Steuermodul 200 in einem weiteren schematischen Schnitt. Die starre Verbindung zwischen der Leiterplatte 204 und dem Kühlkörper 202 ist beispielsweise mittels Senkschrauben 322, 324 hergestellt, welche durch eine jeweilige Durchgangsöffnung der Leiterplatte 204 geführt in ein zugeordnetes Innengewinde des Kühlkörpers 202 eingedreht werden.

Eine Ausnehmung 320a, 320b, 320c, 320d des Kühlkörpers 202 wird beispielsweise von wenigstens zwei durch den Kühlkörper 202 gebildeten Seitenwänden begrenzt. Die Leiterplatte 204 verschließt die Ausnehmung 320a, 320b, 320c, 320d. Innerhalb der jeweiligen Ausnehmung 320a, 320b, 320c, 320d ist die wenigstens eine Vorspanneinrichtung und wenigstens ein Bauelement 206a-h angeordnet. Selbstverständlich kann der Kühlkörper 202 eine oder mehrere Ausnehmungen aufweisen.

Die Vorspanneinrichtung in der Ausnehmung 320a wird durch ein abschnittsweise V-förmiges Druckfederelement 302 gebildet, welches einen zentralen Abschnitt zum Abstützen an dem Gegenlagerabschnitt 210a umfasst. Vom zentralen Abschnitt des Druckfederelements 302 ragen Flügelabschnitt zur Anlage an dem jeweiligen elektronischen Bauelement 206a und 206b ab.

Die Vorspanneinrichtung in der Ausnehmung 320b umfasst ein Druckfederelement 304, dessen Basisabschnitt an dem Gegenlagerabschnitt 210b anliegt. Ein jeweiliger Teil von U-Förmig von dem Basisabschnitt abragenden Abschnitten liegt an dem jeweiligen elektronischen Bauelement 206c, 206d an und drückt dieses in Richtung der Leiterplatte 204. Öffnungsweiten 303 und 305 des Druckfederelements 304 sind unterschiedlich groß, können selbstverständlich auch gleich groß ausgebildet sein.

Die wärmeleitfähige Vorspanneinrichtung in der Ausnehmung 320c umfasst einen jeweiligen durch einen durch einen Hinterschnitt 310, 312 gebildeten Federabschnitt 314, 316 des Kühlkörpers 202 umfasst. Der Federabschnitt 314, 316 ragt schräg von einer Seitenwand der Ausnehmung 320c ab. Selbstverständlich kann eine zusätzliche Druckfeder eine feinere Druckabstimmung ermöglichen. In diesem Fall ist die zusätzliche Druckfeder zwischen dem Federabschnitt 314, 316 und dem elektronischen Bauelement 206e, 206f angeordnet.

Die Vorspanneinrichtung in der Ausnehmung 320d wird durch zwei separate Druckfedern 306 und 308 gebildet, welche bei einer unterschiedlichen Bauhöhe eine im Wesentlichen gleiche Kraft in das jeweilige elektronische Bauelement 206g, 206h einleiten.

Die Vorspanneinrichtungen in den Ausnehmungen 320a und 320b umfassen jeweils das Federelement 302, 304, welches mehrere elektronische Bauelemente 206a und 206b bzw. 206c und 206d in Richtung der Leiterplatte 204 drückt.

Die gezeigten Beispiele der Vorspanneinrichtung begrenzen nicht den Begriff der Vorspanneinrichtung. Vielmehr ist die Auswahl von Vorspanneinrichtungen nicht auf die gezeigten Beispiele begrenzt.

In einem Kühlkörper mit mehreren Ausnehmungen können auch unterschiedlich ausgestaltete Vorspanneinrichtungen angeordnet sein.

## Patentansprüche

1. Ein Steuermodul (200) für eine Beleuchtungseinrichtung (100) eines Kraftfahrzeugs, wobei das Steuermodul (200) einen Kühlkörper (202) und eine Leiterplatte (204) mit wenigstens einem darauf angeordneten elektronischen Bauelement (206) umfasst, wobei das elektronische Bauelement (206) mittels einer wärmeleitfähigen Vorspanneinrichtung (208) zwischen der Leiterplatte (204) und dem Kühlkörper (202) verklemmt ist, wobei die wärmeleitfähige Vorspanneinrichtung (208) sich an einem Gegenlagerabschnitt (210) des Kühlkörpers (202) abstützt, wobei die wärmeleitfähige Vorspanneinrichtung (208) das elektronische Bauelement (206) in Richtung der Leiterplatte (204) drückt, und wobei der Gegenlagerabschnitt (210) mit der Leiterplatte (204) starr verbunden ist, **dadurch gekennzeichnet, dass** die wärmeleitfähige Vorspanneinrichtung (208) ein Druckfederelement (302; 304; 306; 308) umfasst, und dass zwischen der Vorspanneinrichtung (208) und dem Kühlkörper (202) und/oder zwischen der Vorspanneinrichtung (208) und dem elektronischen Bauelement (206) eine Wärmeleitpaste angeordnet ist.

2. Das Steuermodul (200) gemäß dem Anspruch 1, wobei die wärmeleitfähige Vorspanneinrichtung (208) einen durch einen insbesondere durch einen Hinterschnitt (310; 312) gebildeten Federabschnitt (314; 316) des Kühlkörpers (202) umfasst.

3. Das Steuermodul (200) gemäß einem der vorigen Ansprüche, wobei der Kühlkörper (202) eine Ausnehmung (320a; 320b; 320c; 320d) umfasst, innerhalb welcher sich die wärmeleitfähige Vorspanneinrichtung (208) befindet.

4. Das Steuermodul (200) gemäß dem vorigen Anspruch, wobei das wenigstens eine elektronische Bauelement (206) sich innerhalb der Ausnehmung (320a; 320b; 320c; 320d) befindet.

5. Das Steuermodul (200) gemäß einem der vorigen Ansprüche, wobei auf der Leiterplatte (204) ein weiteres elektronisches Bauelement (206b; 206d; 206f; 206h) angeordnet ist, und wobei das weitere elektronische Bauelement (206b; 206d; 206f; 206h) mittels der wärmeleitfähigen Vorspanneinrichtung (208) zwischen der Leiterplatte (204) und dem Kühlkörper (202) verklemmt ist, wobei die Vorspanneinrichtung (208) das weitere elektronische Bauelement (206b; 206d; 206f; 206h) in Richtung der Leiterplatte (204) drückt.

6. Ein Steuergerät (106) für eine
Beleuchtungseinrichtung (100) eines Kraftfahrzeugs, wobei das Steuergerät (106) das Steuermodul (200) gemäß einem der Ansprüche 1 bis 5 umfasst.

7. Ein Lichtmodul (104) für eine
Beleuchtungseinrichtung (100) eines Kraftfahrzeugs, wobei das Lichtmodul (104) das Steuermodul (200) gemäß einem der Ansprüche 1 bis 5 umfasst.

8. Eine Beleuchtungseinrichtung (100) eines Kraftfahrzeugs, welche das Steuergerät (106) gemäß Anspruch 6 und/oder das Lichtmodul (104) gemäß Anspruch 7 umfasst.

## Claims

1. A control module (200) for a lighting device (100) of a motor vehicle, wherein the control module (200) comprises a heat sink (202) and a circuit board (204) on which at least one electronic component (206) is arranged, wherein the electronic component (206) is clamped between the circuit board (204) and the heat sink (202) by means of a thermally conductive preloading means (208), wherein the thermally conductive preloading means (208) is supported on a counter bearing portion (210) of the heat sink (202), wherein the thermally conductive preloading means (208) urges the electronic component (206) toward the circuit board (204), and wherein the counter bearing portion (210) is rigidly coupled to the circuit board (204), **characterized in that** the thermally conductive preloading means (208) comprises a compression spring element (302; 304; 306; 308), and **in that** a heat conductive paste is arranged between the preloading means (208) and the heat sink (202) and/or between the preloading means (208) and the electronic component (206).

2. The control module (200) according to claim 1, wherein the thermally conductive preloading means (208) comprises a spring portion (314; 316) of the heat sink (202) formed in particular by an undercut (310; 312).

3. The control module (200) according to any one of the preceding claims, wherein the heat sink (202) comprises a recess (320a; 320b; 320c; 320d) within which the thermally conductive preloading means (208) is located.

4. The control module (200) according to the preceding claim, wherein the at least one electronic component (206) is located within the recess (320a; 320b; 320c; 320d).

5. The control module (200) according to any one of the preceding claims, wherein a further electronic component (206b; 206d; 206f; 206b) is arranged on the circuit board (204), and wherein the further electronic component (206b; 206d; 206f; 206h) is clamped between the circuit board (204) and the heat sink (202) by means of the thermally conductive preloading means (208), wherein the preloading means (208) urges the further electronic component (206b; 206d; 206f; 206h) toward the circuit board (204).

6. A control device (106) for a lighting device (100) of a motor vehicle, wherein the control device (106) comprises the control module (200) according to any one of claims 1 to 5.

7. A light module (104) for a lighting device (100) of a motor vehicle, wherein the light module (104) comprises the control module (200) according to any one of claims 1 to 5.

8. A lighting device (100) of a motor vehicle, comprising the control device (106) according to claim 6 and/or the light module (104) according to claim 7.

## Revendications

1. Module de commande (200) pour un dispositif d'éclairage (100) d'un véhicule automobile, le module de commande (200) comprenant un dissipateur thermique (202) et une carte de circuit imprimé (204) avec au moins un composant électronique (206) agencé dessus, le composant électronique (206) étant serré entre la carte de circuit imprimé (204) et le dissipateur thermique (202) au moyen d'un dispositif de précontrainte thermoconducteur (208), le dispositif de précontrainte thermoconducteur (208) prenant appui sur une section de contre-appui (210) du dissipateur thermique (202), le dispositif de précontrainte thermoconducteur (208) poussant le composant électronique (206) en direction de la carte de circuit imprimé (204), et la section de contre-appui (210) étant reliée de manière rigide à la carte de circuit imprimé (204), **caractérisé en ce que** le dispositif de précontrainte thermoconducteur (208) comprend un élément de ressort de compression (302; 304; 306; 308) et **en ce qu'**une pâte thermique est agencée entre le dispositif de précontrainte (208) et le dissipateur thermique (202) et/ou entre le dispositif de précontrainte (208) et le composant électronique (206).

2. Module de commande (200) selon la revendication 1, le dispositif de précontraine thermoconducteur (208) comprenant une section à ressort (314; 316) du dissipateur thermique (202) formée en particulier par une contre-dépouille (310; 312).

3. Module de commande (200) selon l'une quelconque des revendications précédentes, le dissipateur thermique (202) comprenant un évidement (320a ; 320b ; 320c ; 320d) à l'intérieur duquel se trouve le dispositif de précontrainte thermoconducteur (208).

4. Module de commande (200) selon la revendication précédente, ledit au moins un composant électronique (206) se trouvant à l'intérieur de l'évidement (320a; 320b; 320c; 320d).

5. Module de commande (200) selon l'une quelconque des revendications précédentes, un composant électronique supplémentaire (206b; 206d; 206f; 206h) étant agencé sur la carte de circuit imprimé (204) et le composant électronique supplémentaire (206b; 206d; 206f; 206h) étant serré entre la carte de circuit imprimé (204) et le dissipateur thermique (202) au moyen du dispositif de précontrainte thermoconducteur (208), le dispositif de précontrainte (208) poussant le composant électronique supplémentaire (206b; 206d; 206f; 206h) dans la direction de la carte de circuit imprimé (204).

6. Appareil de commande (106) pour un dispositif
d'éclairage (100) d'un véhicule automobile, l'appareil de commande (106) comprenant le module de commande (200) selon l'une quelconque des revendications 1 à 5.

7. Module d'éclairage (104) pour un dispositif d'éclairage (100) d'un véhicule automobile, le module d'éclairage (104) comprenant le module de commande (200) selon l'une quelconque des revendications 1 à 5.

8. Dispositif d'éclairage (100) d'un véhicule automobile, comprenant l'appareil de commande (106) selon la revendication 6 et/ou le module d'éclairage (104) selon la revendication 7.
